Europäisches Patentamt

European Patent Office

Office européen des brevets

(11) Publication number: **0 040 546 B1**

# EUROPEAN PATENT SPECIFICATION

(45) Date of publication of patent specification: **13.09.89**

(51) Int. Cl.⁴: **H 01 L 21/316,** H 01 L 21/31

(21) Application number: **81302227.4**

(22) Date of filing: **19.05.81**

(54) Method for forming the insulating layer of a semiconductor device.

(30) Priority: **19.05.80 JP 65233/80**

(43) Date of publication of application:
**25.11.81 Bulletin 81/47**

(45) Publication of the grant of the patent:
**13.09.89 Bulletin 89/37**

(84) Designated Contracting States:
**DE FR GB NL**

(56) References cited:
**DE-A-1 286 872**
**US-A-3 903 325**
**US-A-4 016 007**
**IBM TECHNICAL DISCLOSURE BULLETIN, vol.
21, no. 1, June 1978, pp. 393-394, NEW YORK
(US), E.A. IRENE: "Method to reduce defects in
very thin SiO2 films"**
**IBM TECHNICAL DISCLOSURE BULLETIN, vol.
22, no. 3, August 1979, p. 935, NEW YORK (US),
R. SILVERMAN et al.: "Low temperature
oxidation method for self-passivation of
polysilicon conductors during gate oxide
growth"**

(73) Proprietor: **FUJITSU LIMITED**
**1015, Kamikodanaka Nakahara-ku
Kawasaki-shi Kanagawa 211 (JP)**

(72) Inventor: **Yamamoto, Takashi**
**1600 Shinyoshida-cho
Kohoku-ku Yokohama-shi Kanagawa 223 (JP)**

(74) Representative: **Lawrence, Peter Robin
Broughton et al
GILL JENNINGS & EVERY 53-64 Chancery Lane
London WC2A 1HN (GB)**

Courier Press, Leamington Spa, England.

**Description**

The present invention relates to a method for forming an insulating layer on a polycrystalline silicon layer suitable for use within a semiconductor device.

In FAMOS (Floating gate Avalanche injection Metal Oxide Semiconductor) wherein an electrically conductive polycrystalline silicon layer is used as a floating gate, an insulating oxide layer may be formed on the polycrystalline silicon layer by thermally oxidising the polycrystalline silicon. Leakage current flowing through the insulating layer should be as small as possible. In the case of a dynamic RAM (Random Access Memory) or a CCD (Charged Coupled Device) having a two-layer structure of polycrystalline silicon, an insulating oxide layer lies between the two-layers of polycrystalline silicon and is formed by thermally oxidising the lower polycrystalline silicon layer of the two-layers. Leakage current flowing through the insulating layer should be as small as possible. It is possible to evaluate the resistability of the insulating oxide layer to the leakage current by adopting the breakdown property of the insulating oxide layer. In practice insulating oxide layers should have a breakdown voltage of more than 5 MV/cm.

A method that has previously been considered to be a preferred way of forming on a polycrystalline silicon layer an insulating oxide layer having a high breakdown voltage comprises thermally oxidising the polycrystalline silicon in a dry oxygen atmosphere at a high temperature of about 1200°C. It has recently become possible to produce a single crystalline silicon wafer having a large diameter of 10 cm or more and it has been attempted to simultaneously treat a plurality of silicon wafers both to increase productivity and to reduce production costs.

However, when a polycrystalline silicon layer laying on a large silicon wafer having a diameter of 10 cm or more is thermally oxidised to form an insulating oxide layer in accordance with a conventional oxidation procedure, warp may be generated in the silicon wafer and the thickness of the formed insulating oxide layer may not be uniform. The conventional oxidation procedure comprises the steps of placing a plurality of wafers provided with a polycrystalline silicon layer in a heating furnace having a temperature of from 1050 to 1200°C, oxidising the upper part of the polycrystalline silicon layer in an atmosphere comprising dry oxygen gas and hydrogen chloride gas (anhydrous hydrochloric acid gas) to form an insulating oxide (silicon dioxide) layer having a predetermined thickness, slow cooling the oxidation-treated wafers, and withdrawing the resultant wafer from the heating furnace.

It has been found that when the oxidation of the polycrystalline silicon is conducted at a temperature of up to 1100°C the resultant insulating oxide layer may have an insufficient breakdown voltage, for instance of 3 MV/cm or less. When the oxidation is conducted at 1200°C the resultant insulating oxide layer may have a sufficient breakdown voltage, of 5 MV/cm or more, but it is difficult to form accurately and reproducibly an insulating oxide layer having the desired thinness, for instance having a thickness of several hundred Angstroms, since the oxidation rate accelerates with increasing temperature.

In the invention an insulating layer is formed on a polycrystalline silicon layer by thermally oxidising the polycrystalline silicon layer using an oxidising atmosphere comprising dry oxygen and hydrogen chloride at a temperature of 1050 to 1200°C characterised in that the oxidising atmosphere includes an inert gas, the ratio of the partial pressure of oxygen to the sum of the partial pressures of oxygen and inert gas being up to 0.35.

By the invention it is possible to form an insulating layer having a breakdown voltage of 5 MV/cm or more on a polycrystalline silicon layer by thermal oxidation at a temperature of 1050°C or more, the resultant product being useful for incorporation in a semiconductor device. It is possible to form the layer to controlled and reproducible thickness and without causing warp in any underlying wafer.

It is particularly surprising that these advantageous results are obtainable by the method of the invention since the inclusion of inert gas in a thermal oxidation atmosphere being used for oxidation of single crystalline silicon does not have similar advantages.

The thermal oxidation atmosphere used in the invention may be any thermal oxidation atmosphere suitable for thermally oxidising polycrystalline silicon except that it is modified by the inclusion of inert gas in accordance with the invention. The thermal oxidation atmosphere includes at least one oxidising gas and may include other components to promote the desired oxidation reaction. As is known, the thermal oxidation atmosphere preferably includes also hydrogen chloride gas. The amount of hydrogen chloride, based on the amount of oxygen, is usually quite small, for instance about 1 to 5 volume percent.

Preferably the thermal oxidation atmosphere is free of components other than the dry oxygen, hydrogen chloride or other additive if present, and inert gas. The inert gas may be selected from Ar, He, Ne, Xe or Kr but preferably is argon.

The thermal oxidation is generally conducted, at least in part, at a temperature of from 1050 to 1200°C. When the temperature is such that, in the absence of inert gas, the breakdown voltage of the resultant silicon dioxide layer would be below 5 MV/cm then the amount of inert gas included is chosen such that the breakdown voltage is 5 MV/cm or more. The ratio of the partial pressure of the oxidising gas to the sum of the partial pressures of oxygen and inert gas is up to 0.35. When the temperature is around 1050°C the ratio is generally up to 0.08 whilst if the temperature is around 1100°C the ratio is generally up to around 0.21. Particularly significant improvements in breakdown voltage occur in the invention at thermal oxidation temperatures of up to 1150°C but, as is shown by the data presented below, improvements in breakdown voltage are also obtained at higher temperatures, for instance 1200°C, as a result of the invention.

The thermal oxidation may be conducted in a single treatment or may be initiated by heating the polycrystalline silicon layer initially at a lower temperature than the preferred 1050 to 1200°C oxidation temperature in the presence of a thermal oxidation atmosphere including inert gas, this atmosphere generally being the same atmosphere as is required for the final thermal oxidation stage. This lower temperature may be, for instance, between 900 and 1050°C.

The thermal oxidation is generally followed by cooling the resultant layer from the thermal oxidation temperature in an inert atmosphere.

The duration and other conditions of the oxidation may be such that the polycrystalline layer is oxidised to silicon dioxide throughout its thickness or to a controlled depth.

The invention is now described with reference to the accompanying drawings in which:

Figures 1A through 1E are schematic sectional views of a semiconductor device sample in intermediate stages of production;

Figures 2A, 3A and 4A are histograms showing the relationship between percentage of breakdown number and breakdown voltage of insulating layers which are formed on polycrystalline silicon layers at 1050°C, respectively;

Figures 2B, 3B and 4B are histograms showing the relationship between percentage of breakdown number and breakdown voltage of insulating layers which are formed on single crystalline silicon wafers at 1050°C, respectively;

Figures 5A, 6A and 7A are histograms, being similar to Figure 2A, of insulating layers which are formed at 1100°C;

Figures 5B, 6B and 7B are histograms, being similar to Figure 2B, of insulating layers which are formed at 1100°C;

Figure 8 is a diagram showing the relationship between partial pressure ratio of oxygen gas and breakdown voltage of insulating layer formed by thermally oxidising polycrystalline silicon at 1050°C, 1100°C and 1200°C, respectively;

Figures 9 and 10 are histograms, being similar to Figure 2A, of insulating layers which are formed by two-step thermal oxidation at 1050°C; and

Figures 11, 12 and 13 are histograms, being similar to Figure 2A, of insulating layers which are formed by two-step thermal oxidation at 1100°C.

In order to measure breakdown voltage of insulating layer formed on polycrystalline silicon layer by thermally oxidising the upper part of the polycrystalline silicon layer, semiconductor device samples provided with the insulating layer are produced in the following manner.

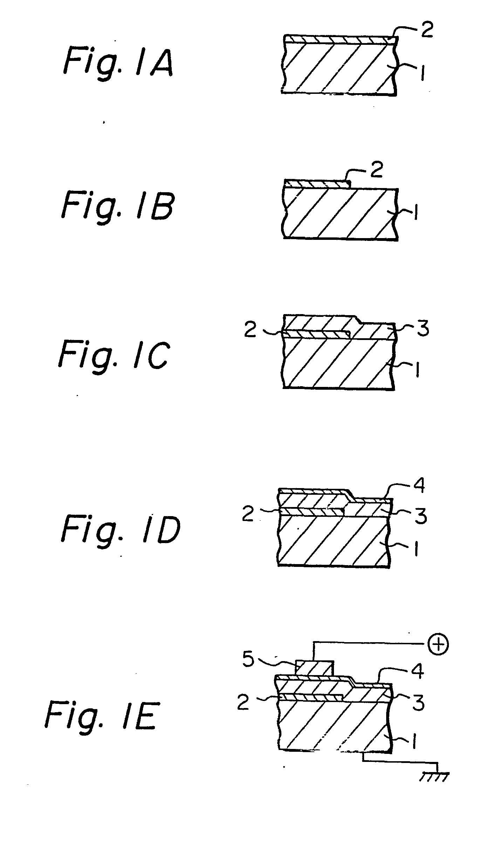

Firstly, a starting material is a single crystalline silicon wafer (n-type, 10~20 ohm · cm, 10 cm diameter) 1 in Figure 1A. A silicon dioxide layer 2 having a thickness of approximately 200 nm (2000 Å) is formed on the silicon wafer 1 by a conventional thermal oxidation process. Then, the silicon dioxide layer 2 is selectively etched by a conventional photoetching process, as illustrated in Figure 1B. A phosphorus doped polycrystalline silicon layer 3 having a thickness of approximately 400 nm is deposited on the wafer 1 and the silicon dioxide layer 2 by a conventional chemical vapour deposition (CVD) process, as illustrated in Figure 1C. The upper part of the polycrystalline silicon layer 3 is thermally oxidised under various conditions, which are explained hereinafter, to form an insulating layer 4 of silicon dioxide on the polycrystalline silicon layer 3, as illustrated in Figure 1D. Then, another phosphorus doped polycrystalline silicon layer 5 having a thickness of approximately 400 nm is deposited on the insulating layer 4 by a conventional CVD process and is selectively etched by a photoetching process to form a large number of electrodes 5 of polycrystalline silicon, as illustrated in Figure 1E. Dimensions of each electrode 5 are 3.2 mm by 5.5 mm. When the silicon wafer 1 is grounded and positive voltage is applied to each of the polycrystalline silicon electrodes 5, namely when the insulating layer 4 is applied with voltage, the leakage current flowing through the insulating layer 4 is measured. When the leakage current (I) reaches 1 µA, the applied voltage value (V) is herein regarded as the breakdown voltage of the insulating layer.

Example 1

A plurality of the above-mentioned wafers (fifty wafers) provided with the polycrystalline silicon layer are arranged in a boat and inserted inho a heating furnace maintained at a predetermined temperature. The wafers are heated in that furnace for a suitable period in an ambient atmosphere that is at atmopsheric pressure and consists of oxygen gas, hydrogen chloride gas and, for the tests according to the invention, various amounts of argon. The amounts of the various gases are shown in Table 1 below. The inclusion of HCl gas is made to increase surface passivation effect against sodium ions.

As a result of the oxidation the upper part at least of the polycrystalline silicon layer 3 is thermally oxidised to a silicon dioxide insulating layer 4 having a thickness shown in Table 1. After the oxidation treatment the flow of oxygen and HCl gas is terminated so that the ambient atmosphere then consists of argon alone. Simultaneously the boat hvaing the wafers is gradually withdrawn from the furnace.

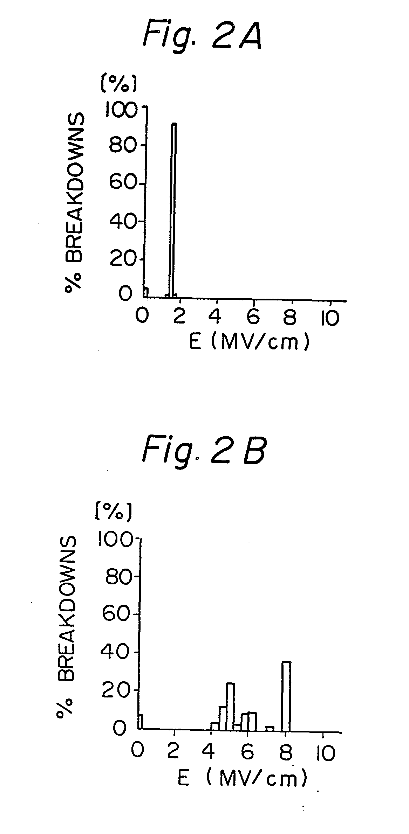

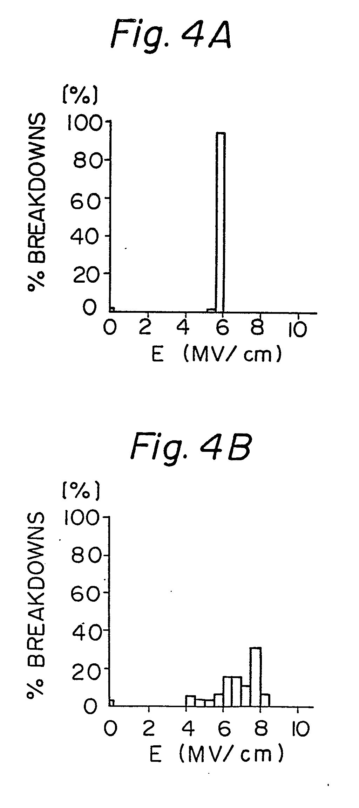

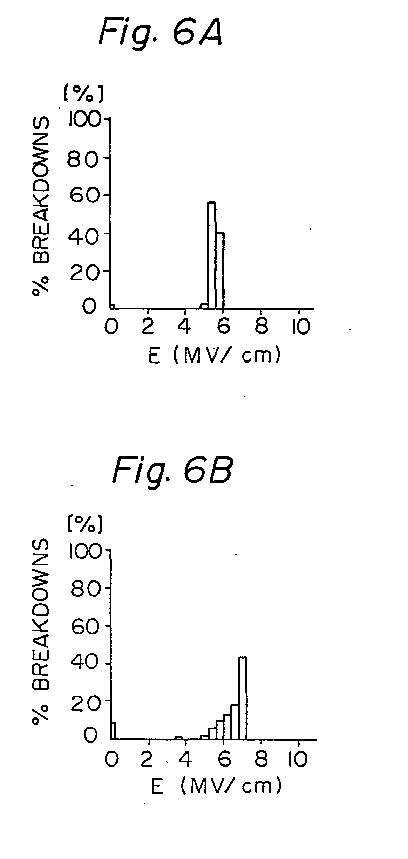

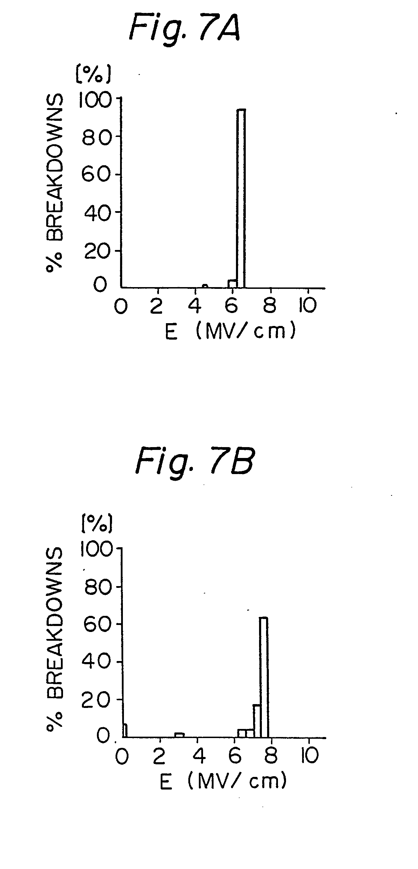

In order to measure the breakdown voltage of the resultant insulating layer, the above-mentioned polycrystalline silicon electrodes are formed. Approximately 100 electrodes are selected from a large number of the electrodes at random and tested to measure the breakdown voltage value thereof, in each of Samples A through I. The obtained results are shown in Figures 2A, 3A, 4A, 5A, 6A and 7A. Figures 2A through 7A are histograms and indicate the samples A through F in Table 1 below respectively. In each of the histograms the ordinate indicates the percentage of number of insulating layers having a certain breakdown voltage, and the abscissa indicates the breakdown voltage.

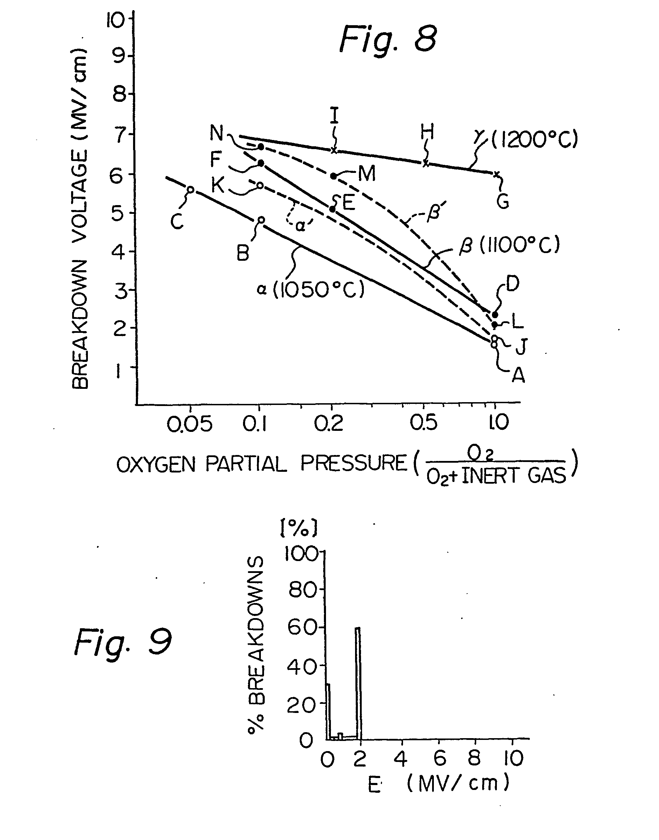

From the obtained results in each case of Samples A, B and C (in Table 1, i.e. shown in Figures 2A, 3A and 4A, respectively), the average value of breakdown voltage meaurements except extremely low measured values can be determined by calculation. The obtained average values of breakdown voltage are indicated by circles A, B and C in Figure 8, respectively. In order to clarify the relationship between the oxygen partial pressure and breakdown voltage, it is possible to draw a line α with respect to the average values, as illustrated in Figure 8.

As is obvious from Figures 2A, 3A and 4A and the line α in Figure 8, as the oxygen partial pressure decreases, the breakdown voltage of the insulating layer of silicon dioxide formed by thermally oxidising the polycrystalline silicon layer increases from approximately 1.5 MV/cm (in Sample A in which the ambient gas does not contain the inert gas) to approximately 5.8 MV/cm (in Sample C).

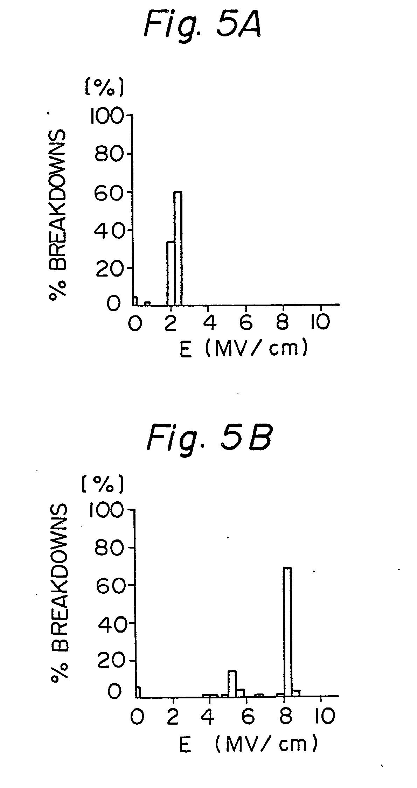

From the obtained results in each case of Samples D, E and F (in Table 1, i.e. shown in Figures 5A, 6A and 7A, respectively), the average value of breakdown voltage measurements except extremely low measured values can be determined by calculation. The average values of breakdown voltage are indicated by black circles D, E and F in Figure 8 respectively. It is also possible to draw a line β with respect to the average values, as illustrated in Figure 8. As is obvious from Figures 5A, 6A and 7A and the line β in Figure 8, as the oxygen partial pressure decreases, the breakdown voltage of the insulating oxide layer increases from approximately 2.2 MV/cm (in Sample D) to approximately 6.4 MV/cm (in Sample F).

In each case of Samples G, H and I in Table 1, a breakdown voltage distribution of all measurement values is not shown, but an average value of the measurements except extremely low measured values can be determined by calculation. The obtained average values of breakdown voltage are indicated by cross G, H and I in Figure 8, respectively. It is also possible to draw a line γ in Figure 8, all average values of breakdown voltage are above 5 MV/cm and the lower the oxygen partial pressure is, the higher the breakdown voltage of the insulating layer is.

As is evident from Figure 8, in a case where the oxygen partial pressure is prescribed, the higher an oxidising temperature (i.e. heating temperature) is, the higher the breakdown voltage of the insulating layer can be made. In order to make the breakdown voltage of the insulating layer formed on the polycrystalline silicon layer above 5 MV/cm, in case of a heating (oxidising) temperature of 1050°C, it is preferable to make the oxygen partial pressure ratio in the ambient gas up to 0.08. In case of a heating temperature of 1100°C; it is preferable to make the oxygen partial pressure ratio up to 0.21. However, as is evident from Table 1, the lower the oxidising temperature is, the smaller the oxidation (formation) rate is for forming the insulating oxide layer. Therefore, in order to form the insulating layer having a predetermined thickness, the oxidising period becomes longer. It is not preferable to make the oxidising period too long. While in case of a heating temperature of 1200°C, a decrease of the oxygen partial pressure can form a thin insulating layer having a predetermined thickness.

Example 2 (comparative)

As comparative examples, an insulating layer of silicon dioxide is formed on a singlecrystalline silicon wafer by thermal oxdiation and then the breakdown property of the formed insulating layer is appraised.

The above-mentioned insulating layer is formed in the following manner. A singlecrystalline silicon wafer (n-type, 10~20 ohm · cm, 10 cm diameter, not shown) is set on the hereinbefore mentioned boat together with the wafers provided with polycrystalline silicon layer (as illustrated in Figure 1C). The boat is inserted into the heating furnace maintained at a predetermined temperature. Thermal oxidation condition for the singlecrystalline wafer is the same as that for polycrystalline silicon layer shown in Table 1. After the thermal oxidation, the phosphorus doped polycrystalline silicon layer is deposited on the formed insulating oxide layer and is selectively etched to form a large number of electrodes of polycrystalline silicon in the above-mentioned manner. Dimensions of each electrode are 3.2 mm by 5.5 mm. When the silicon wafer is grounded and positive voltage is applied to each of the electrodes, the leakage current flowing through the formed insulating layer is measured. Therefore, the leakage current concerning approximately 100 electrodes selected randomly from a large number of the electrodes is measured to define the breakdown voltage thereof. The obtained results are shown in Figures 2B, 3B, 4B, 5B, 6B and 7B. Figures 2B through 7B are histograms being similar to Figures 2A through 7A and the thermal oxidation conditions for Figures 2B through 7B are the same as those for Figures 2A, through 7A, respectively.

As can be seen in Figures 2B, 3B and 4B, the breakdown distribution of the insulating oxide layer formed on the singlecrystalline silicon is not improved, though the oxygen partial pressure decreases. In a case where the insulating layer is formed by thermally oxidising the singlecrystalline silicon wafer at 1100°C, as can be seen in Figures 5B, 6B and 7B, as the oxygen partial pressure decreases, the breakdown distribution of the insulating layer is slightly improved.

TABLE 1
Thermal oxidation condition

| | | Ambient gas | | |
|---|---|---|---|---|
| | Sample | Oxygen gas partial pressure $O_2/O_2+$Inert gas | Inert gas | HCl gas HCl/$O_2\times100$ (Vol. %) |
| | A | 1.0 | — | 1.25 |
| | B | 0.1 | Ar | 5.0 |
| | C | 0.05 | Ar | 5.0 |
| | D | 1.0 | — | 1.25 |
| | E | 0.2 | Ar | 5.0 |
| | F | 0.1 | Ar | 5.0 |
| | G | 1.0 | — | 1.25 |
| | H | 0.5 | Ar | 5.0 |
| | I | 0.2 | Ar | 5.0 |

TABLE 1 (Cont.)

| | Heating condition | | Thickness of insulating layer (nm) | |
|---|---|---|---|---|
| Sample | Temperature (°C) | Time (min.) | On poly-crystalline | On single crystalline |
| A | 1050 | 20 | 63 | 48.5 |
| B | 1050 | 80 | 54 | 44 |
| C | 1050 | 120 | 50.5 | 39 |
| D | 1100 | 12.5 | 64 | 50.5 |
| E | 1100 | 21 | 50 | 41 |
| F | 1100 | 50 | 53 | 45 |
| G | 1200 | 15 | 101.0 | 94 |
| H | 1200 | 24 | 115.5 | 103 |
| I | 1200 | 32 | 99.0 | 94 |

Example 3

A polycrystalline silicon layer formed over a silicon dioxide layer over a silicon wafer as described above is thermally oxidised in a two-stage thermal oxidation process in accordance with the conditions given in Table 2.

EP 0 040 546 B1

TABLE 2
Thermal oxidation condition

| | Ambient gas | | |
|---|---|---|---|
| Sample | Oxygen gas partial pressure $O_2/O_2+$inert gas | Inert gas | HCl gas $HCl/O_2\times100$ (vol.%) |
| J | 1.0 | — | 1.25 |
| K | 0.1 | Ar | 5.0 |
| L | 1.0 | — | 1.25 |
| M | 0.2 | Ar | 5.0 |
| N | 0.1 | Ar | 5.0 |
| O | 1.0 | — | 1.25 |
| P | 0.5 | Ar | 1.25 |
| Q | 0.2 | Ar | 5.0 |

TABLE 2 (Cont.)

| | Heating condition | | | | Thickness of insulating layer (nm) |
|---|---|---|---|---|---|
| | First step | | Second step | | |
| Sample | Temp. (°C) | Time (min.) | Temp. (°C) | Time (min.) | |
| J | 950 | 7 | 1050 | 7 | 51 |
| K | 950 | 7 | 1050 | 70 | 56.5 |
| L | 950 | 7 | 1100 | 1 | 52 |
| M | 950 | 7 | 1100 | 13 | 53.5 |
| N | 950 | 7 | 1100 | 33 | 50.5 |
| O | 950 | 7 | 1200 | 4 | 94.0 |
| P | 950 | 7 | 1200 | 16 | 103.0 |
| Q | 950 | 7 | 1200 | 32 | 94.0 |

A plurality of the wafers (fifty wafers) provided with the polycrystalline silicon layer are arranged in a boat and inserted into a heating furnace having a temperature of 950°C. The wafers are heated (i.e. thermally oxidised) at 950°C for a period of 7 minutes in an ambient gas including an oxygen gas (in a first step of heating condition). The ambient gas has atmospheric pressure and consists of the oxygen gas, the inert gas (argon gas) and a hydrogen chloride gas according to the present invention (in cases of Samples K, M, N, P and Q), or consists of an oxygen gas and a hydrogen chloride gas according to the prior art (in cases of Samples J, L and O). Then, the heating temperature of the furnace is raised up to 1050°C, 1100°C or 1200°C at a predetermined heating rate of 10°C/min. By keeping the furnace at 1050°C, 1100°C or 1200°C for a suitable period (in a second step of heating condition), the polycrystalline silicon layer is further oxidised in the ambient gas to form an insulating oxide layer having a predetermined thickness. The ambient gas containing the oxygen gas flows during the oxidation period and then is changed to another ambient gas consisting of inert gas (argon gas), only. Passing the inert ambient gas, the temperature of the furnace is reduced at a cooling rate of 4°C/min to 950°C. Then, the wafers provided with the formed insulating layer

6

are withdrawn from the heating furnace. Another polycrystalline silicon layer having a thickness of approximately 400 nm is deposited on the insluating layer and is selectively etched to form a large number of electrodes. Dimensions of each electrode are 3.2 mm by 5.5 mm. In order to measure the breakdown voltage of the insulating layer, the wafer is grounded and positive voltage is applied to each of the electrodes, so that the leakage current flowing through the insulating layer can be measured. Judging from the measured leakage current value, the breakdown voltage of the insulating layer is decided. Approximately 100 electrodes are selected from a large number of the electrodes at random and tested to decide the breakdown voltage in every sample J through N. The obtained results are shown in Figures 9 through 13. Figures 9 through 13 are histograms being similar to Figure 2A.

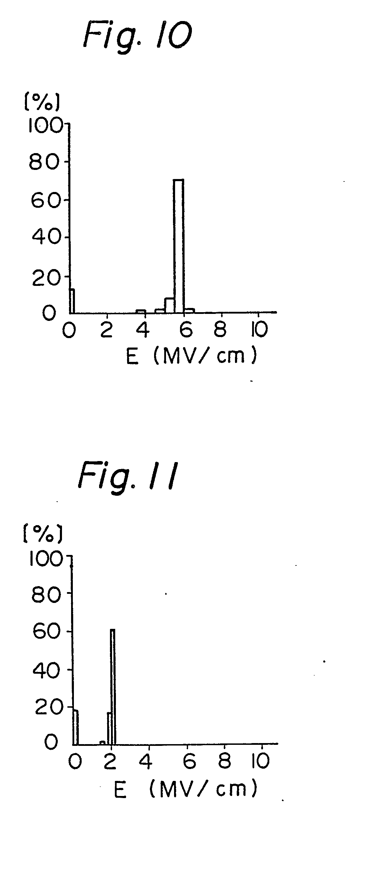

As is obvious from Figures 9 and 10 which indicate cases of Sample J and Sample K in Table 2, respectively, the breakdown distribution of the insulating layer in Sample K (Figure 10) is preferable to that of Sample J (Figure 9) and an average value of breakdown voltage of the insulating layer in Sample K is larger than that of Sample J. The obtained average values of breakdown voltage are indicated by circles J and K and a broke line α' in Figure 8. As the oxygen partial pressure of the ambient gas is low, breakdown property of the insulating layer formed on the polycrystalline silicon layer is superior.

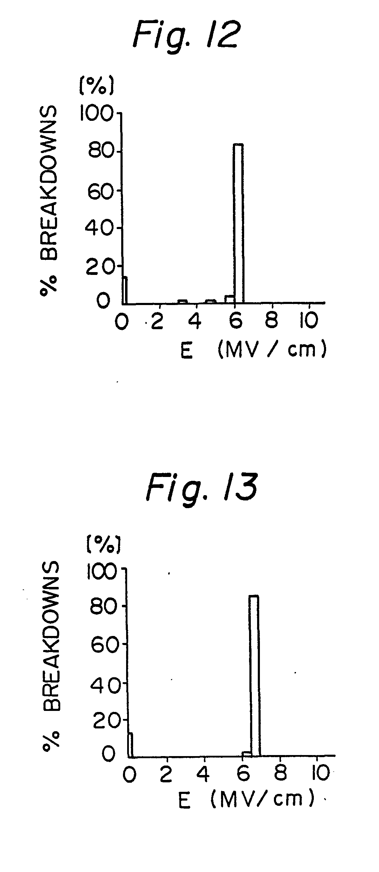

As is obvious from Figure 11 (Sample L in Table 2), Figure 12 (Sample M) and Figure 13 (Sample N), as the oxygen partial pressure decreases, the breakdown voltage of the insulating layer of silicon dioxide increases from approximately 2.1 MV/cm (in Sample L) to approximately 6.8 MV/cm (in Sample N). The obtained average values of breakdown voltage are indicated by black circles L, M and N and a broken line β' in Figure 8.

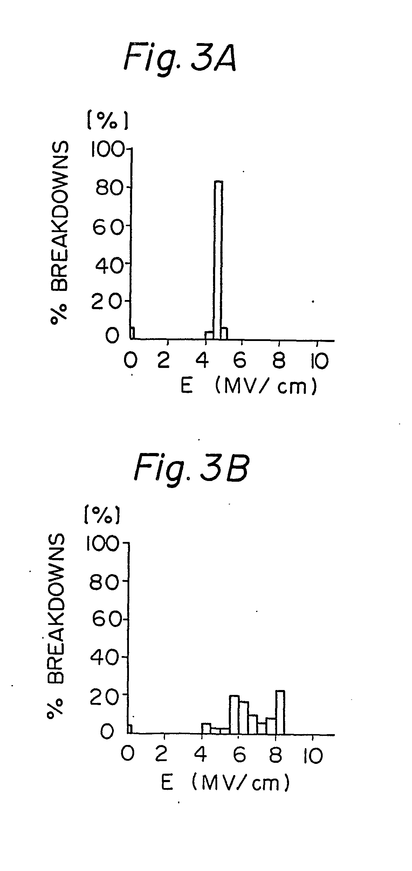

In order to make the breakdown voltage of the insulating layer formed on the polycrystalline layer above 5 MV/cm, in case of a heating temperature at 1050°C it is preferable to make the oxygen partial pressure ratio in the ambient gas up to 0.18 from the broken line α' in Figure 8, and in case of a heating temperature at 1100°C it is preferable to make the oxygen partial pressure ratio up to 0.35 from the broken line β' in Figure 8. By comparing the line α and β with the line α' and β' in Figure 8 and by comparing Figures 2A and 3A with Figures 9 and 10, as well as, Figures 5A, 6A and 7A with Figures 11, 12 and 13 it is seen that the two step thermal oxidation in a mixed gas of an oxygen gas and an inert gas is preferable to the one step thermal oxidation.

It is possible to prevent warp and slip-line of crystalline dislocation in the silicon wafer from occurring by carrying out the two step thermal oxidation. Now in each case of Sample O, P and Q in Table 2, a breakdown voltage distribution of all measurement values is not shown. The obtained average values of breakdown voltage of Sample O, P and Q were approximated to the values of Sample G, H and I in Table 1, respectively.

## Claims

1. A method of forming an insulating oxide layer on a polycrystalline silicon layer by thermally oxidising the polycrystalline silicon layer using an oxidising atmosphere comprising dry oxygen and hydrogen chloride at a temperature of 1050—1200°C characterised in that the oxidising atmosphere includes an inert gas, the ratio of the partial pressure of oxygen to the sum of the partial pressures of oxygen and inert gas being up to 0.35.

2. A method according to claim 1 in which the thermal oxidation is initiated by heating at a temperature below 1050°C in the said thermal oxidation atmosphere.

3. A method of forming an insulating oxide layer on a polycrystalline silicon layer by thermally oxidising the polycrystalline silicon layer using an oxidising atmosphere comprising dry oxygen and hydrogen chloride characterised in that the thermal oxidation is conducted in a two stage process, the temperature being between 900—1050°C in the first stage and between 1050—1200°C in the subsequent second stage, and the oxidising atmosphere includes an inert gas the ratio of the partial pressure of oxygen to the sum of the partial pressures of oxygen and inert gas being up to 0.35.

4. A method according to any preceding claim characterised in that the thermal oxidation atmosphere contains hydrogen chloride in an amount of 1 to 5 volume percent based on the oxidising gas.

5. A method according to any preceding claim characterised in that the inert gas is Ar, He, Ne, Xe or Kr, preferably Ar.

6. A method according to any preceding claim wherein the ratio of partial pressure of oxidising gas to the sum of the partial pressures of oxygen and inert gas is preferably up to 0.08 when the temperature is about 1050°C and up to 0.21 when the temperature is about 1100°C.

7. A method according to any preceding claim characterised in that the thermal oxidation is followed by cooling the insulating layer in an inert atmosphere.

## Patentansprüche

1. Verfahren zur Bildung einer isolierenden Oxidschicht auf einer polykristallinen Siliziumschicht, durch thermisches Oxidieren der polykristallinen Siliziumschicht unter Verwendung einer oxidierenden Atmosphäre, die trockenen Sauerstoff und Chlorwasserstoff bei einer Temperatur von 1050—1200°C umfaßt, dadurch gekennzeichnet, daß die oxidierende Atmosphäre ein Edelgas enthält, wobei das Verhältnis des Partialdruckes des Sauerstoffes zu der Summe der Partialdrücke von Sauerstoff und Edelgas bis zu 0,35 beträgt.

2. Verfahren nach Anspruch 1, bei dem die thermische Oxidation durch Erhitzen auf eine Temperatur unterhalb 1050°C in der genannten thermischen Oxidationsatmosphäre initiiert wird.

3. Verfahren zur Bildung einer isolierenden Oxidschicht auf einer polykristallinen Siliziumschicht, durch thermisches Oxidieren der polykristallinen Siliziumschicht unter Verwendung einer oxidierenden Atmosphäre, die trockenen Sauerstoff und Chlorwasserstoff enthält, dadurch gekennzeichnet, daß die thermische Oxidation in 2 Stufen durchgeführt wird, die Temperatur in der ersten Stufe zwischen 900—1050°C und in der darauf folgenden Stufe zwischen 1050—1200°C liegt und die oxidierende Atmosphäre ein Edelgas enthält, wobei das Verhältnis des Partialdruckes von Sauerstoff zu der Summe der Partialdrücke von Sauerstoff und Edelgas bis zu 0,35 beträgt.

4. Verfahren nach einem der vorhergehenden Ansprüche, dadurch gekennzeichnet, daß die thermische Oxidationsatmosphäre Chlorwasserstoff in einem Betrag von 1 bis 5 Volumen-%, basierend auf dem oxidierende Gas, enthält.

5. Verfahren nach einem der vorhergehenden Ansprüche, dadurch gekennzeichnet, daß das Edelgas Ar, He, Ne, Xe oder Kr ist, vorzugsweise Ar.

6. Verfahren nach einem der vorhergehenden Ansprüche, bei dem das Verhältnis des Partialdruckes von oxidierendem Gas zu der Summe der Partialdrücke von Sauerstoff und Edelgas vorzugsweise bis zu 0,08 ist, wenn die Temperatur bei etwa 1050°C liegt, und bis zu 0,21 ist, wenn die Temperatur bei etwa 1100°C liegt.

7. Verfahren nach einem der vorhergehenden Ansprüche, dadurch gekennzeichnet, daß auf die thermische Oxidation das Abkühlen des isolierenden Schicht in einer inerten Atmosphäre folgt.

**Revendications**

1. Un procédé de formation d'une couche d'oxyde isolante sur une couche de silicium polycristallin par oxydation thermique de la couche de silicium polycristallin utilisant une atmosphère oxydante comprenant de l'oxygène sec et de l'acide chlorhydrique à une température de 1 050—1 200°C caractérisé en ce que l'atmosphère oxydante inclut également un gaz inerte, le rapport de la pression partielle de l'oxygène à la somme des pressions partielles d'oxygène et de gaz inerte atteignant 0,35.

2. Un procédé selon la revendication 1, selon lequel l'oxydation thermique est commencée par chauffage à une température inférieure à 1 050°C dans ladite atmosphère d'oxydation thermique.

3. Un procédé de formation d'un couche d'oyxde isolante sur une couche de silicium polycrystallin par oxydation thermique de la couche de silicium polycristallin utilisant une atmosphère oxydante comprenant de l'oxygène sec et de l'acide chlorhydrique caractérisé en ce que l'oxydation thermique est conduite par un procédé en deux étapes, la température étant comprise entre 900 et 1 050°C dans la première étape et entre 1 050 et 1 200°C dans la seconde étape subséquente, et l'atmosphère oxydante inclut un gaz inerte, le rapport de la pression partielle d'oxygène à la somme des pressions partielles d'oxygène et de gaz inerte atteignant 0,35.

4. Un procédé selon l'une quelconque des revendications précédentes, caractérisé en ce que l'atmosphère d'oxydation thermique contient de l'acide chlorhydrique en quantité de 1 à 5% en volume basée sur le gaz oxydant.

5. Un procédé selon l'une quelconque des revendications précédentes, caractérisé en ce que le gaz inerte est Ar, He, Ne, Xe ou Kr, de préférence Ar.

6. Un procédé selon l'une quelconque des revendications précédentes, selon lequel le rapport de la pression partielle de gaz oxydant à la somme des pressions partielles d'oxygène et de gaz inerte peut atteindre de préférence 0,08 lorsque la température est d'environ 1 050°C et peut atteindre 0,21 lorsque la température est d'environ 1 100°C.

7. Un procédé selon l'une quelconque des revendications précédentes, caractérisé en ce que l'oxydation thermique est suivie du refroidissement de la couche isolante dans une atmosphère inerte.

EP 0 040 546 B1

*Fig. 1A*

*Fig. 1B*

*Fig. 1C*

*Fig. 1D*

*Fig. 1E*

1

## Fig. 2A

## Fig. 2 B

# Fig. 3A

# Fig. 3B

# Fig. 4A

# Fig. 4B

4

# Fig. 5A

# Fig. 5B

## Fig. 6A

## Fig. 6B

EP 0 040 546 B1

## Fig. 7A

## Fig. 7B

7

Fig. 8

Fig. 9

## Fig. 10

## Fig. 11

## Fig. 12

## Fig. 13